# EUROPEAN PATENT APPLICATION

(11) **EP 4 590 076 A1**
(43) Date of publication of application: **23.07.2025**
(21) Application number: 24218975.1
(22) Date of filing: 11.12.2024
(51) Int. Cl.: H05K 1/02, H05K 1/16, H05K 3/32, H01R 13/66, H01R 13/719, H01R 13/648

(54) **BRACKET, PLUG CONNECTOR COMPRISING BRACKET AND METHOD FOR FORMING BRACKET**

(30) Priority: 13.12.2023 CN 202311723544
(71) Applicant: Harting International Innovation AG, 2504 Biel (CH)
(72) Inventor: WU, Zhiyang, 2504 BIEL (CH)
(74) Representative: noventive Patentanwaltsgesellschaft mbH

(57) **Abstract**

The present application discloses a bracket (1), a plug connector comprising the bracket (1), and a method for forming a bracket (1). A bracket (1) disposed in a plug connector is provided, the plug connector being used to connect a cable (2) between electronic devices, the cable (2) comprising a wire core (21) for transmitting signals and a shielding layer (22) surrounding the wire core (21), the shielding layer (22) of the cable (2) being fitted to the bracket (1), wherein a circuit is printed on the bracket (1); and the circuit comprises a filter circuit (10), the filter circuit (10) comprising at least one resistor (101a, 101b) and capacitor (102) connected in parallel, the filter circuit (10) having a first end (10A) and a second end (10B), the first end (10A) being electrically connected to the shielding layer (22) of the cable (2) and acting as a node where the at least one resistor (101a, 101b) and capacitor (102) are connected in parallel, and the second end (10B) of the filter circuit (10) being grounded and acting as another node where the at least one resistor (101a, 101b) and capacitor (102) are connected in parallel.

## Description

### Technical field

The present disclosure relates to the technical field of plug connectors for industrial applications, also referred to as industrial plug connectors, in particular to a bracket which is disposed in a plug connector and capable of further filtering out interference in a cable on the plug connector.

### Background art

In the prior art, cables are provided between many electronic devices to transmit power and/or signals, these cables being connected to the electronic devices by plug connectors. Generally, a cable contains one or more shielding layer, which is in contact with and electrically connected to a metal shielding clamp ring of the plug connector, and also grounded, thereby limiting interference caused by external electromagnetic fields to signals transmitted by the core wire of the cable. However, since a single end of the cable shielding layer is grounded or both ends are grounded, a current will be induced in the cable shielding layer, thus giving rise to additional interference.

EP 3 522 307 A1 discloses an industrial modular plug connector in which the electrical shield connection between the shield layers of a plurality of cables and/or electrical connection to the plug connector housing is made by means of a shield bracket or shield frame.

A conventional approach might be to provide a separate electromagnetic interference filter circuit on the electronic device, to filter out the additional interference caused. However, such a scenario sometimes leads to over-protection, and the interference caused will instead rebound and damage other normal equipment.

At the same time, the addition of any additional circuit equipment to a cable system requires a strict procedure and very high visibility, and this actually hinders ground design.

In summary, the question of how to reduce interference to cables between electronic devices from external electromagnetic fields, while preventing additional electromagnetic interference with a more flexible and simple electromechanical structure, is a problem currently in urgent need of solution by those skilled in the art.

### Summary of the invention

Embodiments of the present application provide a bracket disposed in a plug connector, to at least solve problems in the prior art such as the inability to filter out additional interference introduced by a cable shielding layer itself, and the difficulty of needing to add an additional circuit device to a cable system.

In the following, bracket may be used as an abbreviation for shielding bracket or as a synonym for shielding frame.

The bracket as such is preferably suitable and can therefore be part of an industrial modular plug connector as mentioned in the background section. Industrial plug connectors are specially designed for industrial applications where a high level of protection against dust and water ingress is required and high demands are placed on mechanical vibrations. Industrial plug connectors are therefore particularly robust and have a high level of contact stability even at high vibration amplitudes.

According to one aspect of embodiments of the present application, a bracket disposed in a plug connector is provided, the plug connector being used to connect a cable between electronic devices, the cable comprising a wire core for transmitting signals and a shielding layer surrounding the wire core, the shielding layer of the cable being fitted to the bracket, wherein a circuit is printed on the bracket; and the circuit comprises a filter circuit, the filter circuit comprising at least one resistor and capacitor connected in parallel, the filter circuit having a first end and a second end, the first end being electrically connected to the shielding layer of the cable and acting as a node where the at least one resistor and capacitor are connected in parallel, and the second end of the filter circuit being grounded and acting as another node where the at least one resistor and capacitor are connected in parallel.

In this way, as a result of using a bracket formed with a filter circuit (a mechatronic bracket) to replace a conventional bracket in a plug connector (a mechanical component), induced currents in a ground loop formed due to direct grounding of a shielding layer of a cable can be filtered out by the filter circuit on the bracket. In particular, when a long cable (e.g. more than 15 m long) passes through an electrical device such as a high-power drive motor, a shielding ring current will arise in the shielding layer due to the influence of interfering magnetic flux; because the electric potentials at the two ends of the cable are not equal, a very large electric potential ring current will form, and this ring current will have the effect of cancelling out and attenuating signals transmitted by the cable. However, by providing a filter circuit on the bracket of the plug connector, the ring current can be filtered out, thereby reducing or even eliminating interference to signals transmitted by the cable.

According to an exemplary embodiment of the present application, the bracket is formed of a printed circuit board.

According to an exemplary embodiment of the present application, the bracket is formed of a mechatronic device.

In this way, the bracket can be manufactured simply with a simple structure, in order to be able to replace a conventional bracket of a plug connector in dimensions and shape, and filtering of interference signals can also be achieved.

According to an exemplary embodiment of the present application, the bracket is formed by printing an electrically conductive copper foil pattern on a substrate of a plastic material or aluminium material.

In this way, the choice can be made to use different materials to form the bracket according to actual applications (e.g. different requirements regarding mechanical strength, etc.).

According to an exemplary embodiment of the present application, the printed circuit board has multiple layers, and the at least one resistor and capacitor are printed on the printed circuit board.

In this way, the choice can be made to use printed circuit boards of different layers according to actual applications (e.g. requirements regarding the capabilities of the resistor and capacitor of the filter circuit, etc.).

According to an exemplary embodiment of the present application, the at least one resistor and capacitor are printed on the mechatronic device.

According to an exemplary embodiment of the present application, the resistance of the resistor is of the order of MQ, and the capacitance of the capacitor is of the order of nF.

In this way, the resistance of the resistor or the capacitance of the capacitor can be adjusted according to different application scenarios, so as to suit a variety of scenarios.

According to an exemplary embodiment of the present application, the bracket comprises: a bracket body, with a fixing hole formed in the bracket body to fit the shielding layer of the cable; and two bracket legs, extending from two end sides of the bracket body and fixedly installed in the plug connector so that the bracket is disposed in the plug connector, wherein the bracket legs are electrically grounded, wherein the fixing hole is electrically connected to each of the bracket legs, wherein the at least one resistor and capacitor are both disposed on one of the two bracket legs or respectively disposed on a corresponding one of the two bracket legs.

In this way, the bracket can be manufactured with existing manufacturing equipment by an existing manufacturing method, and the cost of manufacturing the bracket can thus be controlled.

According to an exemplary embodiment of the present application, the bracket body is formed as a plate, and the two bracket legs extend from the two end sides of the bracket body in the same plane as the bracket body or in a different plane from that of the bracket body.

According to an exemplary embodiment of the present application, the bracket body is formed in a 3D irregular shape.

In this way, regularly and irregularly shaped brackets with identical grounding and filtering characteristics can be manufactured, so as to suit a variety of plug connectors.

According to an exemplary embodiment of the present application, the shielding layer is fixed to the bracket using a metal clamp ring, wherein the shielding layer is clamped in a central opening part of the metal clamp ring and in contact with the metal clamp ring, and mounting holes in fixing feet at two ends of the metal clamp ring are matched to the fixing holes and fixed to the fixing holes by fasteners.

According to another aspect of embodiments of the present application, a plug connector is provided, comprising the bracket described above.

According to an exemplary embodiment of the present application, the plug connector is applied in an electrical connection application scenario, the electronic devices comprise a process quantity detection instrument, a control system and an execution system, one end of the cable is connected to the process quantity detection instrument via the plug connector, and another end of the cable is connected to either one of the control system and the execution system via another said plug connector.

In this way, a plug connector having the bracket of the present application can be applied in various electrical connection application scenarios, for example, in application configurations of electronic and electrical systems for upper- and lower-level detection, monitoring and execution and weak-point instruments including process quantity detection instruments, control systems and execution systems, and can filter out high-frequency currents or low-frequency currents that might be induced in a ground loop in various application scenarios.

According to an exemplary embodiment of the present application, the respective shielding layer of said one end and/or said other end of the cable is grounded directly, thereby forming a ground loop with ground, and the filter circuit is used to filter out a current formed in the ground loop.

According to another aspect of embodiments of the present application, a method for forming a bracket is provided, the bracket being disposed in a plug connector, the plug connector being used to connect a cable between electronic devices, the cable comprising a wire core for transmitting signals and a shielding layer surrounding the wire core, the shielding layer of the cable being fitted to the bracket, wherein the method comprises: preparing a substrate of a plastic material or an aluminium material; printing an electrically conductive copper foil pattern layer on the substrate to form at least one resistor and capacitor, the at least one resistor and capacitor forming a filter circuit.

In this way, a bracket with a filter circuit can be manufactured by a simple manufacturing process.

According to an exemplary embodiment of the present application, the bracket is formed of a printed circuit board, wherein the step of printing an electrically conductive copper foil pattern layer on the substrate to form at least one resistor and capacitor comprises: forming a first printed circuit layer on the substrate, the first printed circuit layer comprising the at least one resistor and capacitor.

According to an exemplary embodiment of the present application, the step of printing an electrically conductive copper foil pattern layer on the substrate to form at least one resistor and capacitor further comprises: at least forming a second printed circuit layer complementary to the first printed circuit layer.

According to an exemplary embodiment of the present application, the step of at least forming a second printed circuit layer complementary to the first printed circuit layer comprises: forming at least one middle printed circuit layer between the first printed circuit layer and the second printed circuit layer, wherein another resistor and/or capacitor is additionally formed in the second printed circuit layer.

In this way, circuit boards with various numbers of layers can be designed according to application demands, so as to suit a variety of application scenarios.

According to an exemplary embodiment of the present application, the bracket is formed of a mechatronic device.

In embodiments of the present application, a bracket, a plug connector comprising the bracket, and a method for forming a bracket are provided; by providing a filter circuit in the bracket, it is possible to achieve further filtering of interference in a cable on the plug connector through a more flexible and simple mechatronic structure, without causing additional interference.

### Brief description of the drawings

The drawings described here are intended to provide further understanding of the present application, and form part of the present application; schematic embodiments of the present application and descriptions thereof are intended to explain the present application, without limiting it inappropriately. In the drawings:
Figs. 1A - 1C are exploded schematic drawings of a bracket disposed in a plug connector according to an embodiment of the present application.
Fig. 2 is a schematic drawing of a cable.
Fig. 3 is a schematic circuit diagram of a filter circuit disposed in a bracket.
Fig. 4 is a schematic drawing of a metal clamp ring for fitting a shielding layer of a cable in a bracket.
Fig. 5 is a flow chart of a method for forming a bracket.

### Detailed description of the invention

To enable those skilled in the art to better understand the solution of the present application, the technical solutions in embodiments of the present application are described clearly and completely below with reference to the drawings in embodiments of the present application; obviously, the embodiments described are merely some, not all, of the embodiments of the present application. All other embodiments obtained by those skilled in the art on the basis of embodiments in the present application without inventive effort shall be included in the scope of protection of the present application.

It should be explained that the terms "first", "second", etc. in the Description and claims of the present application and in the abovementioned drawings are used to distinguish between similar objects, and need not be used to describe a specific order or sequence. It should be understood that terms used in this way can be swapped in appropriate circumstances, so that embodiments of the present application described herein can be implemented in orders other than those shown or described herein. In addition, the terms "comprising" and "having" and any variants thereof are intended to encompass non-exclusive inclusion; for example, processes, methods, systems, products or devices including a series of steps or units need not be limited to those steps or units that are set out clearly, and could comprise other steps or units which are not set out clearly or which are intrinsic to these processes, methods, products or devices.

In the prior art, cables are provided between many electronic devices to transmit power and/or signals, these cables being connected to the electronic devices by plug connectors; however, since a single end of a cable shielding layer is grounded or both ends are grounded, a current will be induced in the cable shielding layer, thus giving rise to additional interference. In particular, when a long cable (e.g. more than 15 m long) passes through an electrical device such as a high-power drive motor, a shielding ring current will arise in the shielding layer due to the influence of interfering magnetic flux; because the electric potentials at the two ends of the cable are not equal, a very large electric potential ring current will form, and this ring current will have the effect of cancelling out and attenuating signals transmitted by the cable. For example, all electronic and electrical systems on the body of a new high-speed train are physically connected to the body, so the sensor network of the new high-speed train platform suffers interference from the floating ground. There is a significant issue with the precision of vehicle speed sensors in particular; for example, inductive interference of the cable shielding layer causes a ring current and an error of 4 - 20 mA in the measurement of the output signal. Such interference is low-energy, high-frequency pulses of up to 2 KV, with a duration of the order of milliseconds.

Furthermore, if a separate electromagnetic interference filter circuit is provided on an electronic device, to filter out the additional interference caused, the result will sometimes be over-protection, and the interference caused will instead rebound and damage other normal equipment; therefore, the provision of optional configurations for grounded filters is very important for guaranteeing system performance.

In addition, the addition of any additional circuit equipment to a cable system requires a strict procedure and very high visibility, especially in the case of sensing systems of new high-speed trains, and this actually hinders ground design and/or deployment.

Furthermore, since space is very limited inside the vast majority of plug connectors, it is very difficult to add such a mechanism inside a plug connector to filter out interference. Taking into account the fact that a common grounding point is a shielding bracket of a cable shielding metal network, it was discovered in the course of research by the inventors that most interference is in fact introduced by this cable shielding network, because, for example, cables of up to 15 metres or even longer sometimes need to pass through many electrical devices, especially high-power drive motors. These electric motors produce electromagnetic radiation, thus causing electromagnetic interference issues with peripheral equipment including cables.

To prevent the propagation of electromagnetic interference to ground, it is necessary to install an effective filter and also have a correct cable grounding point. The inventors of the present application discovered that such a shielding bracket inside a plug connector is the optimal site for implementing an effective filter, not only allowing electromagnetic interference from ground to be blocked, but also allowing an effective filter to be realized inside a plug connector with very limited space, thereby obviating the need for any additional filter circuit device for the cable system, simplifying design, and increasing the robustness of a system comprising electrical devices.

The present application was created in accordance with the above creative concept; various aspects of the present application are described in specific terms below.

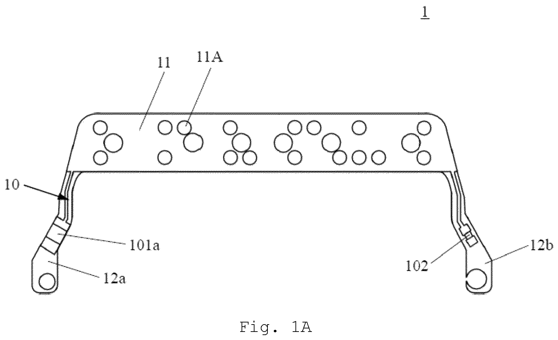

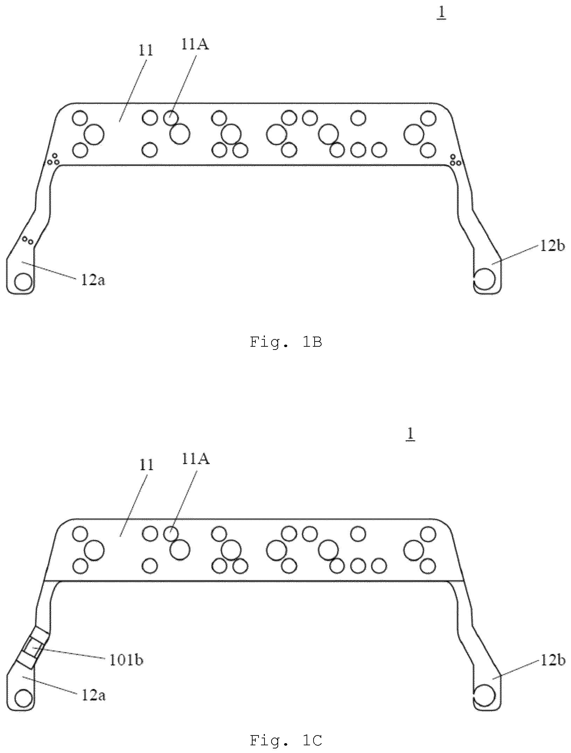

Figs. 1A - 1C are exploded schematic drawings of a bracket 1 disposed in a plug connector according to an embodiment of the present application. In this example, the bracket 1 is formed of a printed circuit board having four printed circuit layers, wherein Fig. 1A shows a top (first) printed circuit layer of the four printed circuit layers, Fig. 1B shows one of two identical middle printed circuit layers of the four printed circuit layers, and Fig. 1C shows a bottom (second) printed circuit layer of the four printed circuit layers; it should be noted that the terms "top...layer" and "bottom...layer" used in the description here are relative; if the bracket is inverted and observed in the opposite direction, the top layer may be regarded as the bottom layer, and the bottom layer may be regarded as the top layer.

In the present application, the plug connector is used to connect a cable between electronic devices; for example, two plug connectors are respectively connected to two ends of the cable and each connected to a corresponding one of two electronic devices, such that the two electronic devices are connected together via the cable so as to transmit various signals to each other.

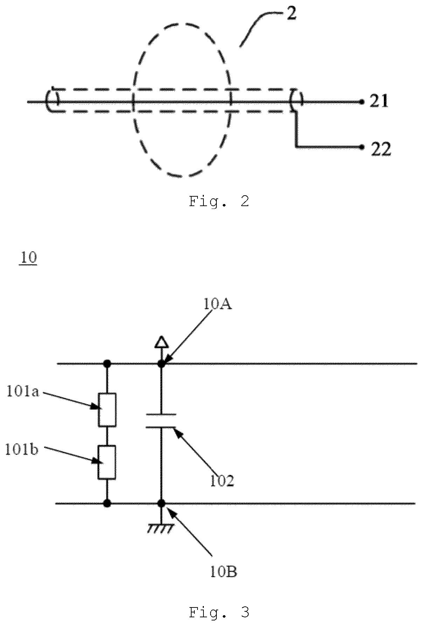

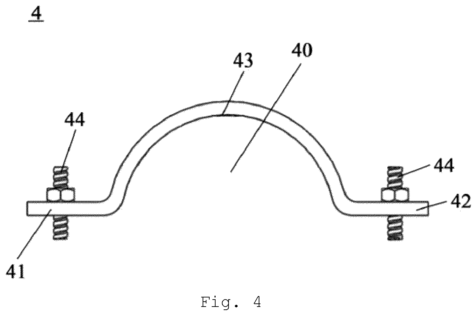

The cable may be a cable 2 as shown in Fig. 2; the cable 2 may comprise a wire core 21 for transmitting signals and a shielding layer 22 surrounding the wire core 21, wherein the shielding layer 22 of the cable 2 may be fitted to the bracket 1, for example using the metal clamp ring shown in Fig. 4, which is described hereinbelow.

As shown in Figs. 1A - 1C, a circuit is printed on the bracket 1; and the circuit comprises a filter circuit 10. As shown in Fig. 3, the filter circuit 10 comprises a capacitor 102, and resistors 101a and 101b (which may be collectively referred to as a resistor 101) connected in parallel with the capacitor 102, wherein the resistor 101a and the resistor 101b are connected in series, and the filter circuit 10 has a first end 10A and a second end 10B; the first end 10A may be electrically connected to the shielding layer 22 of the cable 2 (as shown in Fig. 2) and acts as a node where the capacitor 102 is connected in parallel with the series-connected resistors 101a and 101b, and the second end 10B of the filter circuit 10 is grounded and acts as another node where the capacitor 102 is connected in parallel with the series-connected resistors 101a and 101b.

As an example, the total resistance of the resistors 101a and 101b may be of the order of MΩ, e.g. 1 - 100 MQ; the total resistance of the resistors 101a and 101b depends on the specific application. The capacitance of the capacitor 102 may be of the order of nF, e.g. 10 nF - 500 nF, and depends on the specific application. As an example, the resistors 101a and 101b may have identical or different resistances, e.g. 500 KΩ, 1000 KΩ, 1500 KQ or a larger value; the capacitance of the capacitor 102 may be 50 nF, 100 nF, 200 nF, etc., and its voltage tolerance may be kV. Alternatively, the resistors 101a and 10b may have different resistances.

Although Fig. 3 shows two resistors connected in parallel with one capacitor to form the filter circuit, the configuration of the filter circuit of the present application is not limited to being formed by two resistors and one capacitor; the number of resistor(s) and the number of capacitor (s) may be set according to the specific application and the electrical characteristics of the resistor and capacitor, etc. For example, the filter circuit may be formed by at least one resistor and at least one capacitor.

As an example, the bracket 1 may be formed by printing an electrically conductive copper foil pattern on a substrate of plastic material or aluminium material; for example, the bracket 1 may be formed of a printed circuit board.

Alternatively, the bracket 1 may be formed of a mechatronic device, with a filter circuit printed on the mechatronic device, the filter circuit being formed of at least one resistor and capacitor.

In this text, the case where the bracket 1 is formed of a printed circuit board is taken as a specific example for description; a configuration in which a filter circuit formed of at least one resistor and capacitor is printed on a mechatronic device may be envisaged, designed and implemented by a person skilled in the art on the basis of the technical content disclosed herein.

As shown in Figs. 1A - 1C, the bracket 1 may comprise: a bracket body 11, with fixing holes 11A formed in the bracket body 11 to fit the shielding layer 22 of the cable 2; and two bracket legs, specifically a first bracket leg 12a and a second bracket leg 12b extending from two end sides of the bracket body 11 and fixedly installed in the plug connector so that the bracket 1 is disposed in the plug connector, wherein the first bracket leg 12a and the second bracket leg 12b are both electrically grounded, and the fixing holes 11A are electrically connected to each of the first bracket leg 12a and the second bracket leg 12b to achieve electrical grounding.

A shown in Fig. 1A, in the top printed circuit layer, the resistor 101a is formed on the first bracket leg 12a, and the capacitor 102 is formed on the second bracket leg 12b. Furthermore, as shown in Fig. 1C, in the bottom printed circuit layer, the resistor 101b is formed on the first bracket leg 12a. Furthermore, as shown in Fig. 1B, in this embodiment, there is no resistor and no capacitor formed in the middle printed circuit board layer.

Although this embodiment shows the case where one resistor 101a is formed on the first bracket leg 12a and one capacitor 102 is formed on the second bracket leg 12b in the top printed circuit layer, the present application is not limited to this; for example, one or more resistor could be formed on the first bracket leg 12a, and one or more capacitor could be formed on the second bracket leg 12b, etc. Further, although this embodiment shows the case where only the resistor 101b is formed in the bottom printed circuit layer, as shown in Fig. 1C, the present application is not limited to this; for example, it is also possible for another capacitor to be formed in the bottom printed circuit layer, e.g. on the second bracket leg 12b. As an example, the bottom printed circuit layer could also have the same circuit configuration as the top printed circuit layer. Other circuit configurations of the top printed circuit layer, the middle printed circuit layer and the bottom printed circuit layer are also conceivable, as long as the circuit configuration formed is able to form a filter circuit on the bracket.

The bracket structure shown in Figs. 1A - 1C are merely examples, and the bracket of the present application is not limited to the bracket structure shown in Figs. 1A - 1C.

For example, the bracket of the present application may only comprise a top (first) printed circuit board layer; a top (first) printed circuit board layer and a middle printed circuit board layer; or a top (first) printed circuit board layer and two middle printed circuit board layers, etc.; and the resistor and capacitor may be formed in any one or more of the printed circuit board layers. These details may be designed according to actual application and current/voltage requirements.

Figs. 1A - 1C demonstratively show the case where a resistor and a capacitor are formed on the first bracket leg 12a and the second bracket leg 12b respectively, but this embodiment is merely an example, and the present application is not limited to this example; for example, a resistor and a capacitor could be provided on the first bracket leg 12a, or a resistor and a capacitor could be provided on the second bracket leg 12b, or a resistor and/or a capacitor could be provided on the first bracket leg 12a and a resistor and/or a capacitor could be provided on the second bracket leg 12b, etc. All arrangements of resistors and capacitors on the first bracket leg 12a and the second bracket leg 12b which are conceivable by those skilled in the art fall within the scope of the present disclosure.

As shown in Figs. 1A - 1C, in this example, the bracket body 11 may be formed as a plate, and the first bracket leg 12a and the second bracket leg 12b may each extend from the two end sides of the bracket body 11 in the same plane as the bracket body 11. However, the present application is not limited to this; for example, the first bracket leg 12a and the second bracket leg 12b could each extend from the two end sides of the bracket body 11 in a different plane from that of the bracket body 11. Alternatively, the bracket body 11 could also be formed in a 3D irregular shape.

As stated above, the shielding layer 22 of the cable 2 may be fitted to the bracket 1 using the metal clamp ring shown in Fig. 4. As shown in Fig. 4, the metal clamp ring 4 may comprise a central opening part 40 and fixing feet 41 and 42 at two ends of the metal clamp ring 4. The shielding layer 22 of the cable 2 may be clamped in the central opening part 40 of the metal clamp ring 4, the shielding layer 22 being in contact with a clamp ring wall 43 of the metal clamp ring 4 that defines the central opening part 40. The fixing feet 41 and 42 at the two ends of the metal clamp ring 4 have mounting holes, which may be aligned and matched to the fixing holes 11A in the bracket body 11, and fixed to the fixing holes 11A by fasteners 44, thereby fitting the shielding layer 22 of the cable 2 to the bracket 1.

The bracket of the present application as described above has a filter circuit printed thereon, and is therefore able to filter out interference signals in a ground loop and also realize an effective filter inside a plug connector with very limited space, thereby obviating the need for any additional filter circuit device for an electronic device or cable system, simplifying design, and increasing the robustness of a system comprising electrical devices.

The present application also provides a plug connector, comprising the bracket shown in Figs. 1A - 1C. The plug connector is able to filter out currents induced in a shielding layer of a cable connected to the plug connector, and thus prevent additional electromagnetic interference, especially in application scenarios where the cable is very long, e.g. application scenarios where a cable of up to 15 metres or even longer sometimes needs to pass through electrical devices such as high-power drive motors in a high-speed train.

Specifically, the plug connector may be used in an electrical connection application scenario. As an example, an electronic device may comprise a process quantity detection instrument, a control system and an execution system; one end of a cable is connected via the plug connector to the process quantity detection instrument, and another end of the cable is connected to either one of the control system and the execution system via another plug connector. The respective shielding layer of one end and/or the other end of the cable is grounded directly, thereby forming a ground loop with ground, and the filter circuit is used to filter out currents induced in the ground loop.

As an example, the process quantity instrument may comprise a sensor system of a train, and the sensor system may comprise, for example, a vehicle speed sensor of the train; the control system may comprise a vehicle speed controller for controlling the vehicle speed of the train; and the execution system comprises a brake, an actuator, etc. Thus, in an application scenario in which the plug connector of the present application is applied to a high-speed train, interfering current signals in a cable connecting the vehicle speed sensor to the control system or execution system can be filtered out, for example low-energy, high-frequency pulses of up to 2 KV with a duration of the order of milliseconds. This makes it possible to provide the vehicle speed precision which the vehicle speed sensor should provide, thus providing train safety.

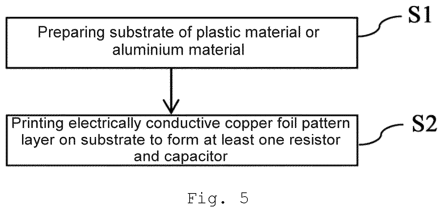

The present application also provides a method for forming the bracket shown in Figs. 1A - 1C. Fig. 5 is a flow chart of a method for forming a bracket. As shown in Fig. 5, the method comprises: step S1, preparing a substrate of a plastic material or an aluminium material with the shape and structure of the bracket shown in Fig. 1A for example; and step S2, printing an electrically conductive copper foil pattern layer on the substrate, to form at least one resistor and capacitor which form a filter circuit.

As an example, step S2 of printing an electrically conductive copper foil pattern layer on the substrate to form at least one resistor and capacitor may comprise: forming a first printed circuit layer on the substrate, the first printed circuit layer comprising at least one resistor and capacitor, as shown in Fig. 1A; and at least forming a second printed circuit layer complementary to the first printed circuit layer, wherein another resistor is formed in the second printed circuit layer, as shown in Fig. 1C. Alternatively, another resistor and/or capacitor may be formed in the second printed circuit layer.

Further, at least forming a second printed circuit layer complementary to the first printed circuit layer may comprise: forming at least one middle printed circuit layer between the first printed circuit layer and the second printed circuit layer, e.g. the middle printed circuit layer shown in Fig. 1B.

In the present application, a bracket, a plug connector comprising the bracket, and a method for forming a bracket are provided. As a result of using a bracket formed with a filter circuit to replace a conventional bracket in a plug connector, induced currents in a ground loop formed due to direct grounding of a shielding layer of a cable can be filtered out by the filter circuit on the bracket.

Specifically, the bracket of the present application may at least have the following advantages:
error-proofing in the design of a cable system;
the flexibility of deployment of grounded filters is increased as required;
the use of a mechatronic device component can stabilize a sensing network;
plug connector weight is reduced;
plastic material can be used instead of aluminium material to form the bracket;
the mechatronic shielding bracket integrated with the required filter circuit formed by the resistor and capacitor can facilitate correct grounding and eliminate interference of a connected electronic device.

In the above embodiments of the present application, the description of each embodiment has its own focus; for anything not described in detail in an embodiment, the relevant description of another embodiment can be referred to.

The above are merely preferred embodiments of the present application, and it should be pointed out that a person skilled in the art could still make a number of improvements and modifications without departing from the principles of the present application, and all such improvements and modifications should be regarded as being within the scope of protection of the present application.

## Claims

1. Bracket (1) disposed in a plug connector, the plug connector being used to connect a cable (2) between electronic devices, the cable (2) comprising a wire core (21) for transmitting signals and a shielding layer (22) surrounding the wire core (21), the shielding layer (22) of the cable (2) being fitted to the bracket (1), wherein a circuit is printed on the bracket (1); and the circuit comprises a filter circuit (10), the filter circuit (10) comprising at least one resistor (101a, 101b) and capacitor (102) connected in parallel, the filter circuit (10) having a first end (10A) and a second end (10B), the first end (10A) being electrically connected to the shielding layer (22) of the cable (2) and acting as a node where the at least one resistor (101a, 101b) and capacitor (102) are connected in parallel, and the second end (10B) of the filter circuit (10) being grounded and acting as another node where the at least one resistor (101a, 101b) and capacitor (102) are connected in parallel.

2. Bracket (1) according to claim 1, wherein the bracket (1) is formed of a printed circuit board.

3. Bracket (1) according to claim 1 or 2, wherein the bracket (1) is formed of a mechatronic device.

4. Bracket (1) according to any one of the claims 1 to 3, wherein the bracket (1) is formed by printing an electrically conductive copper foil pattern on a substrate of a plastic material or aluminium material.

5. Bracket (1) according to any one of the claims 2 to 4, wherein the printed circuit board has multiple layers, and the at least one resistor (101a, 101b) and capacitor (102) are printed on the printed circuit board.

6. Bracket (1) according to any one of the claims 3 to 5, wherein the at least one resistor (101a, 101b) and capacitor (102) are printed on the mechatronic device.

7. Bracket (1) according to any one of the claims 1 to 6, wherein the resistance of the at least one resistor (101a, 101b) is of the order of MΩ, and the capacitance of the capacitor (102) is of the order of nF.

8. Bracket (1) according to any one of claims 1 to 7, wherein the bracket (1) comprises:
a bracket body (11), with a fixing hole formed in the bracket body (11) to fit the shielding layer (22) of the cable (2); and
two bracket legs (12A, 12B), extending from two end sides of the bracket body (11) and fixedly installed in the plug connector so that the bracket (1) is disposed in the plug connector, wherein the bracket legs (12A, 12B) are electrically grounded,
wherein the fixing hole is electrically connected to each of the bracket legs (12A, 12B),
wherein the at least one resistor (101a, 101b) and capacitor (102) are both disposed on one of the two bracket legs (12A, 12B) or respectively disposed on a corresponding one of the two bracket legs (12A, 12B).

9. Bracket (1) according to Claim 8, wherein the bracket body (11) is formed as a plate, and the two bracket legs (12A, 12B) extend from the two end sides of the bracket body in the same plane as the bracket body (11) or in a different plane from that of the bracket body (11).

10. Bracket (1) according to claim 8 or 9, wherein the bracket body (11) is formed in a 3D irregular shape.

11. Bracket (1) according to any one of the claims 8 to 10, wherein the shielding layer (22) is fixed to the bracket (1) using a metal clamp ring (4), wherein the shielding layer (22) is clamped in a central opening part of the metal clamp ring (4) and in contact with the metal clamp ring (4), and mounting holes in fixing feet (41, 42) at two ends of the metal clamp ring (4) are matched to the fixing holes (11A) and fixed to the fixing holes (11A) by fasteners (44).

12. Plug connector, comprising the bracket (1) according to any one of claims 1 to 11.

13. Plug connector according to claim 12, wherein the plug connector is applied in an electrical connection application scenario, the electronic devices comprise a process quantity detection instrument, a control system and an execution system, one end of the cable (2) is connected to the process quantity detection instrument via the plug connector, and another end of the cable (2) is connected to either one of the control system and the execution system via another said plug connector.

14. Plug connector according to claim 13, wherein the respective shielding layer (22) of said one end and/or said other end of the cable (2) is grounded directly, thereby forming a ground loop with ground, and the filter circuit (10) is used to filter out a current formed in the ground loop.

15. Method for forming a bracket (1) according to any one of the claims 1 to 11, the bracket (1) being disposed in a plug connector, the plug connector being used to connect a cable (2) between electronic devices, the cable (2) comprising a wire core (21) for transmitting signals and a shielding layer (22) surrounding the wire core (21), the shielding layer (22) of the cable (2) being fitted to the bracket (1), wherein the method comprises:
In a first step (S1) preparing a substrate of a plastic material or an aluminium material;
In a second step (S2) printing an electrically conductive copper foil pattern layer on the substrate to form at least one resistor (101a, 101b) and capacitor (102), the at least one resistor (101a, 101b) and capacitor (102) forming a filter circuit (10).

16. Method according to claim 15, wherein the bracket (1) is formed of a printed circuit board, wherein the step of printing (s2) an electrically conductive copper foil pattern layer on the substrate to form at least one resistor (101a, 101b) and capacitor (102) comprises:
forming a first printed circuit layer on the substrate, the first printed circuit layer comprising the at least one resistor (101a, 101b) and capacitor (102).

17. Method according to claim 16, wherein the step of printing (S2) an electrically conductive copper foil pattern layer on the substrate to form at least one resistor (101a, 101b) and capacitor (102) further comprises:
at least forming a second printed circuit layer complementary to the first printed circuit layer, and wherein preferably the step of at least forming a second printed circuit layer complementary to the first printed circuit layer comprises:
additionally forming one or more middle printed circuit layer between the first printed circuit layer and the second printed circuit layer,
wherein another resistor and/or capacitor is formed in the second printed circuit layer.
